# EUROPEAN PATENT SPECIFICATION

(11) **EP 0 224 968 B1**
(45) Date of publication and mention of the grant of the patent: **26.05.1993**
(21) Application number: 86202124.3
(22) Date of filing: 28.11.1986
(51) Int. Cl.: H01L 29/06

(54) **Dielectric passivation**
Dielektrische Passivierung
Passivation diélectrique

(30) Priority: 05.12.1985 US 805500
(43) Date of publication of application: 10.06.1987
(73) Proprietor: Philips Electronics N.V., 5621 BA Eindhoven (NL)
(72) Inventor: Stupp, Edward Henry, NL-5656 AA Eindhoven (NL); Vera, Eduardo Sobrino, NL-5656 AA Eindhoven (NL)
(74) Representative: Rensen, Jan Geert

(56) References cited:
- EP-A- 0 139 764
- US-A- 3 686 544
- US-A- 4 292 642
- US-A- 4 300 150
- US-A- 4 521 446
- IEEE TRANSACTIONS ON ELECTRON DEVICES, vol. ED-28, no. 12, December 1981, pages 1455-1466, New York, US; S. Calak : "Effects of Drift Region Parameters on the Static Properties of Power LDMOST".

## Description

The invention relates to a semiconductor high-voltage device comprising a substrate layer of a first conductivity type, an epitaxial layer of a second conductivity type overlying said substrate layer, an insulating layer covering at least a portion of said epitaxial layer and an electrode layer covering at least portions of said insulating layer.

In the development of high-voltage integrated circuits, an important factor is the fabrication of high-voltage lateral devices that make efficient use of the device surface area. A succesful approach that has been developed is the so-called "RESURF" (REduced SURface Field) method described in US-A-4,292,642. A particular choice of doping concentration and epitaxial thickness of the semiconductor layers, such that the product of doping concentration and thickness is approximately 10¹² cm⁻², produces a strong reduction of the surface field in this technique. Consequently, the voltage range at which these devices can safely operate increases.

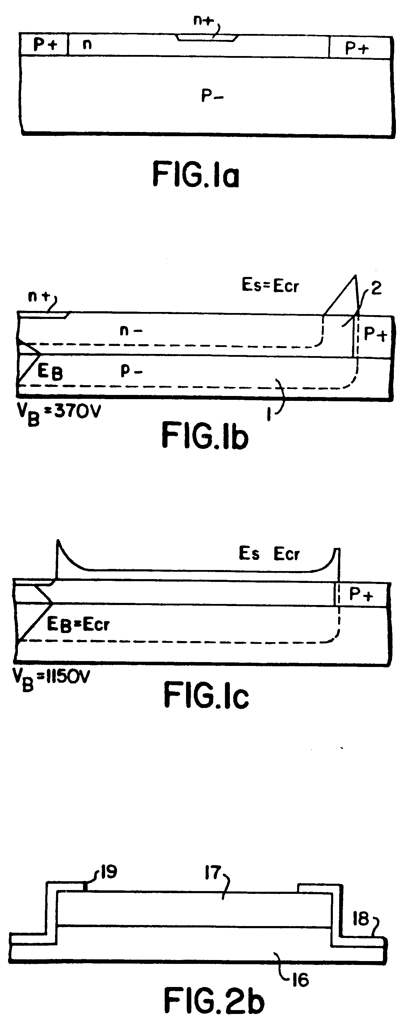

In the instance of a simple prior art diode structure, such as seen in Figure 1a, it is possible to increase the breakdown voltage V_{B} with thick epitaxial layers. Such a thick epitaxial layer 2 on the substrate 1 in Figure 1b may provide, for instance, a breakdown voltage of 370 volts. A reduction in surface field in the structure may be achieved when obtaining an ideal "RESURF" condition (constant electric field along nearly the complete device surface) as seen in Figure 1c. The breakdown voltage may then be increased to 1150 volts, with a nearly constant surface field.

For other, less symmetric structures, such as in the case of geometrical irregularities, the electric field in the vicinity of such irregularities departs from a constant value. Another major difficulty exists in fabrication because of the great sensitivity of such structures to the presence of both external and internal charges. The presence of such charges adversely affects the electrical properties of high-voltage transistors and produces regions of large electrical potential gradient with consequently low avalanche breakdown voltages.

From US-A-4,300,150 a device as mentioned in the opening paragraph is known. To improve its breakdown voltage this known device is provided with a field shaping semiconductor layer. In practice using such a field shaping layer is expensive, since the layer is difficult to manufacture. It is necessary to deposit and pattern a mask on the surface, to diffuse or implant and anneal the field shaping layer at high temperatures and to remove the mask again. An extra difficulty occurs, because diffused and implanted regions formed before manufacturing the field shaping layer will be affected by the high temperature used in manufacturing the field shaping layer.

Conventional techniques of protecting semiconductor devices have been used, but these conventional passivation schemes only shelter the device from contamination or external charges. Such conventional passivations schemes have little or no influence on the effect that internal charges in the device have on the device electric field distribution. These conventional passivation schemes consist of adding at least one layer of a material over the entire device area such as oxygen-doped silicon ("SIPOS") a plasma nitride, a plasma oxide, a low temperature oxide, etc. Some of these materials furthermore exhibit finite electrical conductivity, such as the SIPOS devices, which make them less suited as passivation layers because of the high power dissipation and larger gate to drain leakage current that can arise.

The present invention relates to a passivation scheme which not only shelters the device from external charges, but also alters the distribution of electric fields in the device to make it less vulnerable to the presence of internal charges. This tends to enhance the "RESURF" action by making the electric field distribution in the device even more constant and less sensitive to the effects of non-ideal geometries which occur in real devices.

The inventive semiconductor device is characterised in that a passivating layer having a high dielectric constant at least ten times higher than that of silicon-dioxide is present on a portion of said insulating layer (normally an oxide layer) and that the electrode layer is present on edges of said passivating layer. Preferably the dielectric constant is at least 80 (ε > = 80).

Thus, the present invention involves using a non-conductive dielectric material as an active passivation layer which shelters the device from electrical charges while also reducing the electric fields on its surface.

The structure and features of the present invention may be understood by reference to the drawing features which illustrate, without limitation, an embodiment of the present invention, and wherein:
Figure 1a, 1b and 1c illustrate prior art variations in the cross section of a "RESURF"-type diode;
Figure 2a illustrates a cross sectional view of a lateral DMOST high-voltage structure according to the present invention with a passivating layer having a high dielectric constant;
Figure 2b illustrates an enlarged view of the passivating layer with high dielectric constant according to the present invention in Figure 2a;
Figure 3 illustrates the electrical equipotential contours for a device according to the prior art;
Figure 4a illustrates the electrical equipotential contours of a device according to the present invention;
Figure 4b illustrates an enlarged view of the surface region of Figure 4a;
Figure 5 provides a graphic illustration of the breakdown voltage versus distance from the surface;
Figure 6 provides a graphic illustration of the breakdown voltage versus the static dielectric constant; and
Figure 7 provides a graphic illustration of the breakdown voltage versus interface charge density according to the present invention.

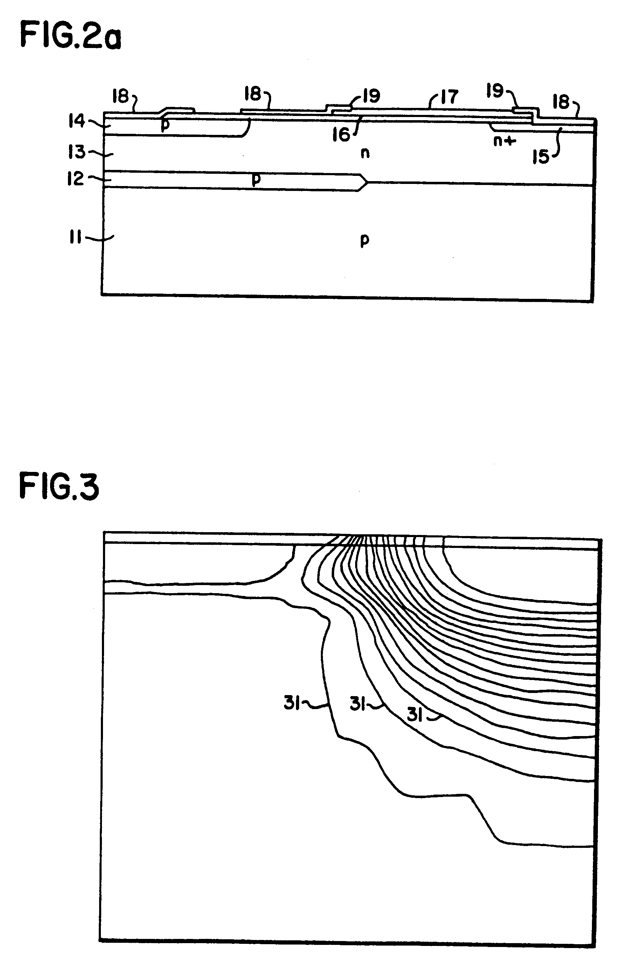

The present invention is explained with reference to a lateral DMOST device of the "RESURF" type as illustrated in Figure 2. This device includes a silicon substrate 11 of a first conductivity type, a buried layer 12 of the same conductivity type at the surface of the substrate 11, an epitaxial layer 13 of a second opposite conductivity type on the substrate 11 and buried layer 12, a surface layer 14 of the first conductivity type, and a surface layer 15 of the second conductivity type. Each of these layers may be appropriately doped layers of silicon.

An insulating layer 16 of SiO₂ is provided over a portion of the surface of the epitaxial layer 13 and the surface layers 14 and 15. On the insulating layer 16 a layer 17 of high dielectric constant is provided as a passivation layer over a portion of both the epitaxial layer 13 and surface layer 15. An example of such a passivation layer 17 is titanium dioxide (TiO₂) with a large static dielectric constant of approximately one order of magnitude larger than the dielectric constant of passivation materials commonly used such as silicon-dioxide. An electrode 18 of aluminium is provided at the surface of the device covering a small portion 19 of the edges of layer 17.

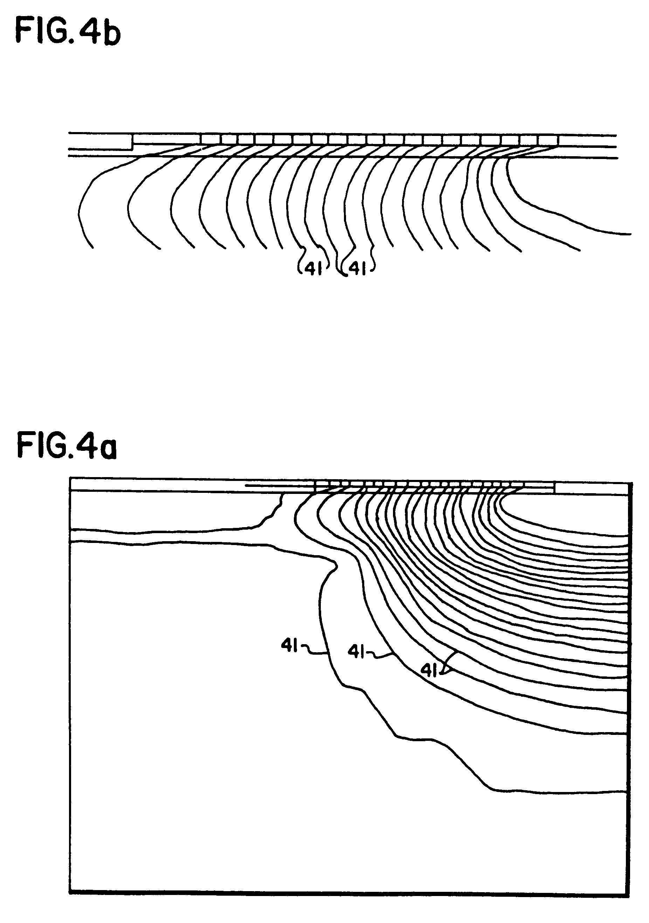

This structure may be further understood by reference to the graphical representations. For instance, Figure 3 provides a graphical illustration of the potential distribution in a lateral DMOST being made according to the prior art that has a passivation layer with a low dielectric constant value in comparison with the present invention. The electric equipotential contours 31 in Figure 3 (41 in Figure 4) have intervals of 20 volts. Figure 4, on the other hand, modifies the potential distribution illustrated in Figure 3 by the introduction of the high dielectric constant passivation layer 17, such as shown in Figure 2. The effect of this high dielectric passivation layer becomes similar to that of an ohmic material although its origin is different. These materials are better suited layers under switching conditions and in addition will exhibit negligible gate to drain leakage. The electric equipotential contours 41 in Figure 4 are provided for a high-voltage lateral DMOST structure with a dielectric layer having a dielectric constant of approximately 80. The breakdown voltage in this case would be approximately 412 volts, whereas the breakdown voltage for the conventional structure illustrated in Figure 3 without the high dielectric constant passivating layer according to the present invention would be approximately 339 volts.

The breakdown voltage is further illustrated as a function of the distance from the dielectric layer to the surface for a high-voltage lateral DMOST structure having passivating layers. The distance d from the dielectric layer 17 to the surface of the epitaxial layer 13 as illustrated in Figure 2b, is 0.1 micron, which is an optimum for the TiO₂ passivation layer. The thickness of the passivation layer 17 is preferably 1 micron. Figure 5 illustrates the conditions of passivating layers of low dielectric constant of 3.9 (a) [prior art], and high dielectric constants, such as 80 (b), 800 (c), and 8000 (d) [present invention].

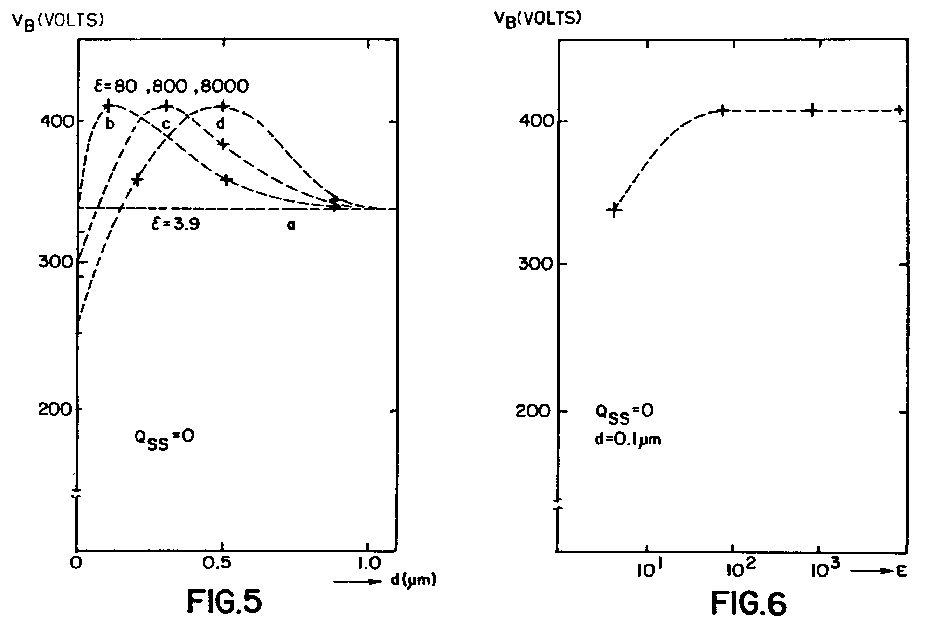

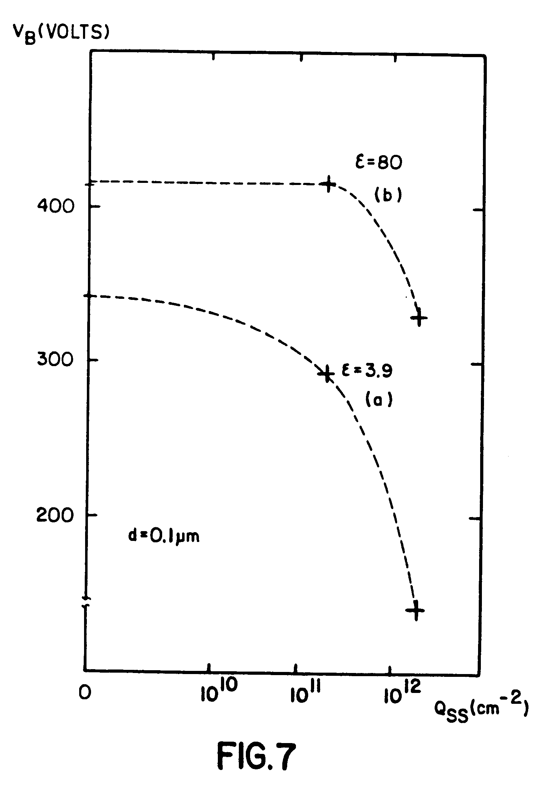

Figure 6 illustrates the breakdown voltage as a function of the static dieletric constant ε of the passivating layer for a high-voltage lateral DMOST structure. Figure 7 illustrates the breakdown voltage as a function of the interface charge density Qₛₛ for a high-voltage lateral DMOST structure having passivating layers of (a) low dielectric constant of the prior art of approximately 3.9, and (b) high dielectric constant of the present invention of about 80. This illustrates that the structure of Figure 2 would be much less sensitive to internal charges. Figures 5 and 6 emphasize that the more linear potential gradient according to the present invention results in a higher breakdown voltage with about a 20 % increase in breakdown voltage.

The present invention is also applicable to other semiconductor devices, such as bi-polar transistors.

## Claims

1. A semiconductor high-voltage device comprising a substrate layer of a first conductivity type, an epitaxial layer of a second conductivity type overlying said substrate layer, an insulating layer covering at least a portion of said epitaxial layer and an electrode layer covering at least portions of said insulating layer, characterised in that a passivating layer having a high dielectric constant at least ten limes higher than that of silicon-dioxide is present on a portion of said insulating layer and that the electrode layer is present on edges of said passivating layer.

2. A semiconductor device according to Claim 1, wherein said passivating layer has a thickness of approximately 1 µm.

3. A semiconductor device according to Claim 1 or Claim 2, wherein said passivating layer consists of titanium dioxide (TiO₂).

4. A semiconductor device according to Claim 1 or Claim 2, wherein said passivating layer has a dielectric constant of at least 80.

5. A semiconductor device as claimed in any one of Claims 1-4, characterised in that the epitaxial layer has a doping concentration and a thickness which are so low that the product of doping concentration (in cm⁻³) and thickness (in cm) is approximately dual to 10¹² cm⁻² according to the "RESURF" condition.

## Patentansprüche

1. Hochspannungs-Halbleiteranordnung mit einer Substratschicht von einem ersten Leitfähigkeitstyp, wobei eine Epitaxialschicht eines zweiten Leitfähigkeitstyps auf der Substratschicht liegt, eine Isolierschicht wenigstens einen Teil der Epitaxialschicht bedeckt und eine Elektrodenschicht wenigstens Teile der Isolierschicht bedeckt, dadurch gekennzeichnet, daß eine Passivierschicht mit hoher dielektrischer Konstante, die wenigstens das Zehnfache höher ist als die des Siliziumdioxids, auf einem Teil der Isolierschicht und die Elektrodenschicht auf Rändern der Passivierschicht vorgesehen sind.

2. Halbleiteranordnung nach Anspruch 1, worin die Passivierschicht eine Dicke von etwa 1 µm hat.

3. Halbleiteranordnung nach Anspruch 1 oder 2, worin die Passivierschicht aus Titandioxid (TiO₂) besteht.

4. Halbleiteranordnung nach Anspruch 1 oder 2, worin die Passivierschicht eine dielektrische Konstante von wenigstens 80 besitzt.

5. Halbleiteranordnung nach einem oder mehreren der Ansprüche 1...4, dadurch gekennzeichnet, daß die Epitaxialschicht eine Dotierungskonzentration und eine Dicke hat, die so niedrig sind, daß das Produkt von Dotierungskonzentration (in cm⁻³) und Dicke (in cm) ungefähr gleich 10¹² cm⁻² entsprechend der "RESURF"-Bedingung ist.

## Revendications

1. Dispositif semiconducteur à haute tension comportant une couche de substrat d'un premier type de conductivité, une couche épitaxiale d'un second type de conductivité, superposée à ladite couche de substrat, une couche isolante recouvrant au moins une partie de ladite couche épitaxiale et une couche d'électrode recouvrant au moins des parties de cette couche isolante, caractérisé en ce que, sur une partie de ladite couche isolante est prévue une couche de passivation ayant une constante diélectrique élevée, au moins dix fois plus élevée que celle du bioxyde de silicium, et en ce que la couche d'électrode est située sur des bords de ladite couche de passivation.

2. Dispositif semiconducteur selon la revendication 1, dans lequel ladite couche de passivation a une épaisseur de l'ordre de 1 µm.

3. Dispositif semiconducteur selon la revendication 1 ou 2, dans lequel ladite couche de passivation est en bioxyde de titane (TiO₂).

4. Dispositif semiconducteur selon la revendication 1 ou 2, dans lequel ladite couche de passivation a une constante diélectrique d'au moins 80.

5. Dispositif semiconducteur selon l'une quelconque des revendications 1 à 4, caractérisé en ce que la couche épitaxiale a une concentration de dopage et un épaisseur tellement faibles que le produit de la concentration de dopage (en cm⁻³) et de l'épaisseur (en cm) est à peu près égal à 10¹² cm⁻² conformément à la condition "RESURF".
